# EUROPÄISCHE PATENTSCHRIFT

(11) **EP 0 415 246 B1**
(45) Veröffentlichungstag und Bekanntmachung des Hinweises auf die Patenterteilung: **20.09.1995**
(21) Anmeldenummer: 90116031.7
(22) Anmeldetag: 22.08.1990
(51) Int. Cl.: H05K 7/14

(54) **Baugruppenträger**
Electronic rack
Rack électronique

(30) Priorität: 29.08.1989 DE 3928461
(43) Veröffentlichungstag der Anmeldung: 06.03.1991
(73) Patentinhaber: AEG Intermas GmbH, 64546 Mörfelden-Walldorf (DE)
(72) Erfinder: Haxel, Gerd, D-6453 Seligenstadt (DE); Zebisch, Manfred, D-8544 Georgensgmünd (DE); Hörbe, Siegfried, D-6393 Wehrheim 1 (DE)
(74) Vertreter: Stoffregen, Hans-Herbert, Dr. Dipl.-Phys.

(56) Entgegenhaltungen:
- DE-U- 8 803 544
- FR-A- 2 266 426
- FR-A- 2 460 091

## Beschreibung

Die Erfindung bezieht sich auf einen Baugruppenträger mit einer oberen metallischen Abdeckplatte und mit zwei metallischen Seitenwänden, zwischen denen an den vier Ecken jeweils Profilschienen aus Metall verlaufen, die an den Seitenwänden befestigt sind und Führungshalter tragen, die für die Aufnahme von Baugruppen bestimmt sind, wobei die Abdeckplatte abgewinkelte Ränder aufweist, die sich über die Breite der Abdeckplatte und bis auf an den Ecken freie Bereiche über die Länge der Abdeckplatte erstrecken, und wobei die über die Länge der Abdeckplatte sich erstreckenden Ränder innen an den Seitenwänden angeschraubt sind.

Ein Baugruppenträger der vorstehend beschriebenen Art ist aus der Firmendruckschrift Siemens-Katalog ET1, 1983, "Einbautechnik und Stromversorgung für Industrieelektronik" bekannt. Bei diesem Baugruppenträger sind die oberen und unteren Profilschienen auf den einander zugewandten Seiten L-förmig abgesetzt. Die abgewinkelten vorderen und rückseitigen Ränder der Abdeckplatten ragen in die freien Räume der Absätze.

Bekannt sind auch Baugruppenträger mit zwei metallischen Seitenwänden, zwischen denen an den vier Ecken jeweils Profilschienen aus Metall verlaufen, die an den Seitenwänden befestigt sind und Führungshalter tragen, die für die Aufnahme von Baugruppen bestimmt sind (DE-A-24 15 001). Diese Baugruppen weisen zumeist Leiterplatten mit Frontleisten auf. An den oberen und unteren Rändern werden die Leiterplatten in Nuten der Führungshalter eingesetzt. An der rückwärtigen Wand des jeweiligen Baugruppenträgers ist eine Reihe von Steckverbindern angebracht, die mit Steckverbindern auf den Leiterplatten der eingesetzten Baugruppen in Eingriff stehen. Zwischen den Steckverbindern der rückwärtigen Wand verlaufen Leitungen, z. B. auf einer gedruckten Leiterplatte. Die elektrischen Verbindungen zwischen den Bauelementen auf verschiedenen Baugruppen und zwischen Bauelementen auf den Baugruppen und Bauelementen außerhalb der Baugruppen verlaufen im allgemeinen über die rückseitigen Steckverbinder. Es sind aber auch Leitungen unmittelbar zwischen benachbarten Baugruppen und Leitungen von den Frontseiten der Baugruppen zu externen Geräten oder Bauelementen möglich.

In den Baugruppen werden vielfach Bauelemente und Schaltungsanordnungen verwendet, die bei hohen oder sehr hohen Frequenzen arbeiten. Da bei diesen Frequenzen störende elektromagnetische Wellen auftreten können, müssen die Baugruppenträger abgeschirmt werden, um das Austreten elektromagnetischer Wellen aus dem jeweiligen Baugruppenträger zu verhindern oder die Wellen wenigstens so stark zu dämpfen, daß sie andere elektrische Einrichtungen nicht mehr stören. In manchen Fällen muß auch die im Inneren eines Baugruppenträgers angeordnete Schaltung gegen von außen einwirkende elektromagnetische Störungen geschützt werden.

Der Erfindung liegt die Aufgabe zugrunde, einen Baugruppenträger der im Oberbegriff des Anspruchs 1 beschriebenen Art dahingehend weiterzuentwickeln, daß auf einfache Weise mit geringem Montageaufwand eine gute Abschirmung gegen elektromagnetische Felder erreicht wird.

Die Aufgabe wird erfindungsgemäß dadurch gelöst, daß eine untere metallische Abdeckplatte die abgewinkelte Ränder aufweist, die sich über die Breite der Abdeckplatte und bis auf an den Ecken freie Bereiche über die Länge der Abdeckplatte erstrecken mit den sich über die Länge der Abdeckplatte erstreckenden Rändern innen an den Seitenwänden befestigt Ist, und daß die in der Breite des Baugruppenträgers verlaufenden Ränder der oberen und unteren Abdeckplatte je in eine Profilschienennut ragen, in der eine oder mehrere Federn Kräfte auf die Ränder und die Wand der Profilschienennut ausüben.

Mit der Abdeckplatte bzw. dem Abdeckblech wird eine elektrisch leitende Verbindung zwischen den Profilschienen und zu den Seitenwänden hergestellt. Die Abdeckbleche lassen sich schnell und einfach montieren. Die Profilschienen weisen bei Baugruppenträgern üblicherweise Längsnuten auf. Eine dieser Nuten kann für die Federn ausgenutzt wreden. An den Seitenwänden sind im allgemeinen bei Baugruppenträgern Bohrungen vorhanden oder können ohne grossen Aufwand angebracht werden. Die Seitenwände und die Profilschienen können daher auch für Baugruppenträger ohne Abschirmung eingesetzt werden.

Bei einer bevorzugten Ausführungsform weist eine Profilschienenlängsnut an der Öffnung einen von der Seitenwand ausgehenden leistenförmigen Vorsprung auf, der die in der Nut angeordnete Feder, die einen V-förmigen Querschnitt aufweist, zurückhält. Die Feder ist insbesondere mit den Enden der beiden Schenkel dem Nutboden zugewandt, während sich das Federjoch am Vorsprung abstützt. Befindet sich kein Abdeckblechrand in der Nut, dann lehnen sich die Schenkel an die Seitenwände an. Der Abdeckblechrand kann mit einem Handgriff in die Nut eingeschoben werden, wobei der an einer Wand anliegende Schenkel der Feder nach der Seite gedrückt wird.

Vorzugsweise sind an den Längsrändern der Feder zackenförmige Vorsprünge vorgesehen. Diese Vorsprünge bilden definitive Auflagestellen zwischen Feder und Nutwand sowie zwischen Feder und Rand der Abdeckplatte. Da die Vorsprünge an der Nutwand und dem Rand an vorbestimmten Stellen anliegen, wird ein bestimmter Übergangswiderstand erreicht, der unabhängig von Toleranzen der Feder oder der Profilschienennut ist.

Es ist günstig, wenn die seitlichen Ränder innen an den Seitenwänden angeschraubt sind, wobei die Bereiche an den Ecken der Abdeckplatten frei von Rändern sind. Im Bereich der Ecken erstrecken sich die Profilschienen unmittelbar an der Seite des Abdeckblechs bis zu den Seitenwänden.

Um die Frontseite des Baugruppenträgers abzuschirmen, sind metallisch oder metallisierte Frontplatten der Baugruppen je mit ins Innere des Baugruppenträgers vorspringenden Steckkontakten versehen, die in mit den Profilschienen verbundenen Federkontakten einfügbar sind. Eine Verbesserung der Abschrimung an der Frontseite lässt sich erreichen, wenn die Frontplatten jeweils an den vertikalen Rändern ins Innere des Baugruppenträgers ragende metallische oder metallisierte Leisten aufweisen, von denen eine eine Gleitfeder trägt und die andere als Kontaktfläche für die leitende Verbindung mit der Gleitfeder der Leiste der im Baugruppenträger benachbarten Frontplatte ausgebildet ist.

Die Rückseite des Baugruppenträgers kann durch eine Leiterplatte mit einer leitenden Schichte abgedeckt sein, die Löcher für Stifte der Steckverbinder trägt. Eine bessere Abschirmung lässt sich erreichen, wenn an der Rückseite eine Abdeckplatte angebracht wird, die ebenso wie die obere und untere Abdeckplatte aus Metall besteht und mit abgewinkelten Rändern in Nuten von rückseitigen Profilschienen eingesetzt ist. Kontaktfedern stellen hierbei eine Leitende Verbindung zwischen den Rändern und den Profilschienennuten her.

Die Erfindung wird im folgenden anhand eines in einer Zeichnung dargestellten Ausführungsbeispiels näher beschrieben, aus dem sich weitere Einzelheiten, Merkmale und Vorteile ergeben.

Es zeigen:
- Fig. 1: einen Baugruppenträger im Querschnitt,
- Fig. 2: den in Fig. 1 dargestellten Baugruppenträger im Bereich der oberen Profilschienen,
- Fig. 3: ein Abdeckblech in Seitenansicht,
- Fig. 4: eine Feder in Seitenansicht,
- Fig. 5: die Feder gemäss Fig. 4 im Querschnitt.
- Fig. 6: einen Querschnitt durch den vorderen Teil einer Baugruppe,
- Fig. 7: einen weiteren Baugruppenträger im Querschnitt.

Ein Baugruppenträger 1 enthält zwei Seitenwände 2 und vier Profilschienen 3, 4, 5 und 6, die sich zwischen den Seitenwänden 2 erstrecken und jeweils an den vier Ecken der Seitenwände 2 an diesen befestigt sind. Die Profilschienen 3 bis 6 weisen jeweils in Längsrichtung verlaufende Löcher 7 auf, in die von den Seitenwänden 2 aus durch Bohrungen Schneidschrauben eingesetzt sind, um die Seitenwände 2 mit den Profilschienen 3 bis 6 zu verschrauben. Die Seitenwände 2 und die Profilschienen 3 bis 6 bestehen aus Metall, insbesondere aus Aluminium.

Zwischen den Profilschienen 3, 4, 5 und 6 erstrecken sich Führungshalter 8, 9, die durch Rastverbindungen an den Profilschienen befestigt sind. Die Führungshalter 8, 9 stehen sich auf verschiedenen Seiten des Baugruppenträgers 1 gegenüber und sind mit nicht näher bezeichneten Nuten versehen, deren offene Längsseiten einander zugewandt sind. In die Nuten sind Baugruppenträger 10, die Leiterplatten 11 mit nicht näher dargestellten elektrischen bzw. elektronischen Bauelementen tragen, mit dem oberen und unteren Rand der jeweiligen Leiterplatte 11 eingesetzt. Die Leiterplatten 11 tragen an ihren rückseitigen Enden Messerleisten 12, die in Federleisten 13 eingreifen, wenn die Baugruppe 10 ihre Endposition in den Führungshaltern 8, 9 erreicht hat. Die Federleisten 13 sind an der rückwärtigen Seite des Baugruppenträgers 1 befestigt. Im allgemeinen weist jede Baugruppe 10 eine Frontleiste 14 auf, die sich bei eingeschobener Leiterplatte 11 mit ihrem oberen und unteren Ende an den Profilschienen 3 und 4 abstützt. Die Frontleiste 14 kann auch in speziell abgewandelter Form einen Frontsteckverbinder für den Anschluss von Leitungen bzw. Kabeln an die Bauelemente des Baugruppenträgers 10 aufweisen.

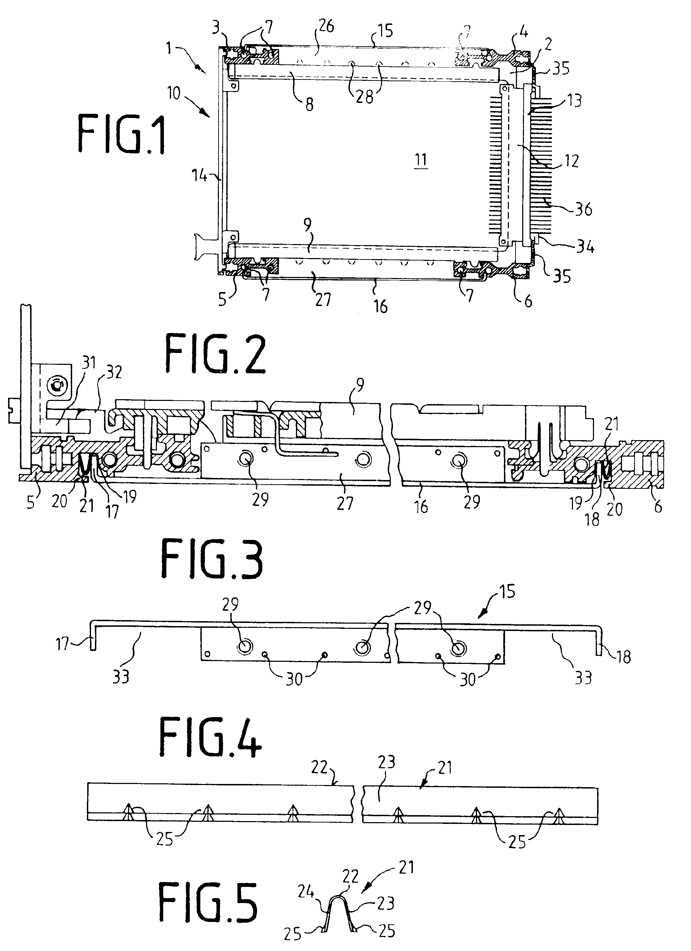

Wenn die auf den Baugruppen 10 angeordneten Schaltungen mit hochfrequenten oder sehr hochfrequenten Schwingungen arbeiten, ist es häufig notwendig, den Baugruppenträger 1 abzuschirmen, um das Austreten elektromagnetischer Strahlung zu dämpfen oder zu verhindern. Die metallischen Seitenwände und die metallischen Profilschienen 3 bis 6 eignen sich als Bestandteile eines Abschirmsystems. Die Führungshalter 8, 9 bestehen meist aus Kunststoff, d. h. sie können keine abschirmende Wirkung ausüben. Um die Ober- und die Unterseite des Baugruppenträgers 1 abzuschirmen, sind zwei Abdeckplatten 15, 16 bzw. Abdeckbleche vorgesehen, die zwischen den Profilschienen 3, 4 bzw. 5, 6 verlaufen. Eine Abdeckplatte 15 ist für sich in Seitenansicht in Fig. 3 dargestellt. Die Abdeckplatten 15, 16 bestehen aus Metallblech, insbesondere aus Aluminiumblech.

An den Enden, die in der Breite des Baugruppenträgers 1 verlaufen, haben die Abdeckplatten 15, 16 abgewinkelte Ränder 17, 18, die in montiertem Zustand des jeweiligen Abdeckbleches in Nuten 19 der Profilschienen 5, 6 bzw. 3, 4 ragen. Die Nuten 19, die auch als Profilschienennuten bezeichnet sind, entsprechen in der Tiefe mindestens der Höhe der Ränder 17, 18. Jeweils an einem Rand an der Öffnung jeder Nut befindet sich ein leistenförmiger Vorsprung 20, der sich über die Länge der Nut 19 erstreckt. Der Vorsprung 20 geht von einer Seitenwand der Nut 19 aus und überdeckt ein Teil der Nut 19.

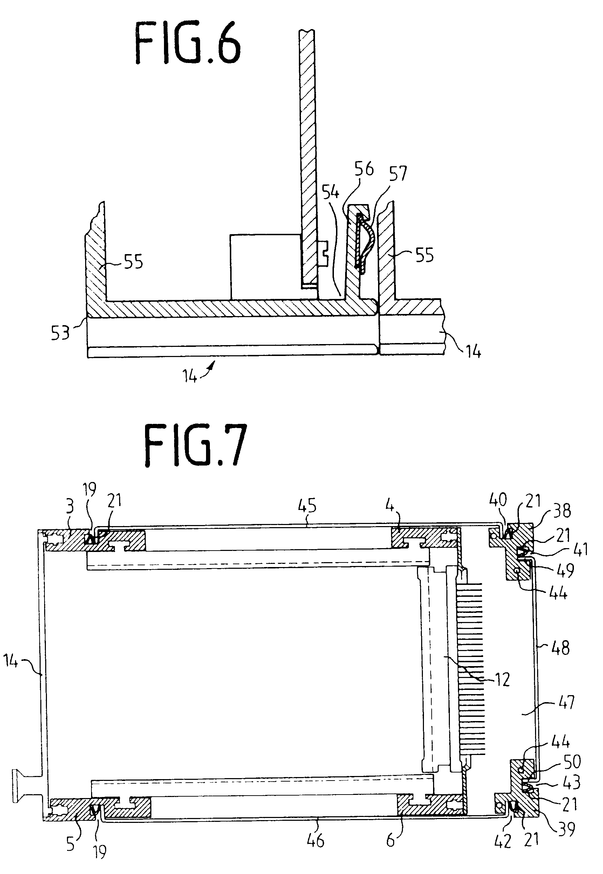

In die Nuten 19 werden Federn 21 eingesetzt, die sich ebenfalls über nahezu die gesamte Nutlänge erstrecken. Die Federn 21, die im einzelnen in den Fig. 4 und 5 dargestellt sind, haben einen V-förmigen Querschnitt und bestehen aus einem vorzugsweise bogenförmigen Joch 22 mit zwei Schenke In 23, 24. In Längsrichtung der Federn ragen an beiden Schenke In 23, 24 zackenförmige Vorsprünge 25 nach aussen. Die Federn 21 werden in die Nuten 19 eingesetzt, wobei die offenen Enden dem Nutgrund zugewandt sind, während sich die Joche an den Vorsprüngen 20 abstützen, die verhindern, dass die Federn 21 die Nuten 19 verlassen.

Bei montierten Abdeckblechen 15, 16 wird z. B. die Schenkel 23 mit den Vorsprüngen 25 gegen die Ränder 17, 18 gedrückt, während die Schenkel 24 mit den Vorsprüngen 25 gegen die eine Nutenwand gedrückt werden. Es wird daher an definierten Stellen eine gut leitende Verbindung zwischen den Abdeckblechen 15, 16 und den Profilschienen 3 bis 6 erzeugt, die im allgemeinen Massepotential führen.

An denjenigen Enden der Abdeckplatten 15, 16, die sich in Richtung der Seitenwände 2 erstrecken, sind ebenfalls abgewinkelte Ränder 26, 27 vorgesehen. Der Winkel, den die Ränder 26, 27 mit den Ebenen der Abdeckplatten 15, 16 einschliessen, beträgt wie bei den Rändern 17, 18 etwa 90°.

Die Ränder 26, 27 liegen an den Innenseiten der Seitenwände 2 an. In den Seitenwänden 2 sind in Höhe der Ränder 26, 27 Bohrungen 28 vorgesehen, die sich in einer Reihe erstrecken.

Die Bohrungen 28 sind in Fig. 1 gestrichelt dargestellt. Mit einigen der Bohrungen koreespondieren in den Rändern 26, 27 Gewindebohrungen 29. Von der Aussenseite der Seitenwände 2 werden in diejenigen Bohrungen 28, die mit Gewindebohrungen 29 flüchten, nicht näher dargestellte Schrauben eingefügt, mit denen die Ränder 26, 27 an die Seitenwände zur Herstellung einer leitenden Verbindung angedrückt werden. An den Rändern 26, 27 sind in Längsrichtung in einer Reihe Noppen 30 vorgesehen, die gegen die Seitenwände 2 vorspringen. Diese Noppen 30 werden beim Anschrauben fest gegen jeweilige Seitenwand 2 angedrückt und gewährleisten eine Reihe von Druckauflagestellen. Hierdruch wird eine gute Abschirmwirkung erreicht.

Um die Abschirmung zu vervollständigen, ist zweckmässigerweise eine metallische Frontleiste 14, bzw. eine Frontleiste mit einer metallischen Beschichtung vorgesehen. Von der Frontleiste springt ein Steckkontakt 31 in Richtung des jeweiligen Führungshalters 8 vor, dessen Anfang gegen die vordere Stirnseite der Profilschiene 7 zurückgesetzt ist. Auf der Profilschiene 7 ist ein Federkontakt 32 befestigt, in den der Steckkontakt 31 eingreift und damit eine leitende Verbindung zwischen der metallischen Frontleiste 14 bzw. der metallischen Schicht der Frontleiste und der Profilschiene 8 herstellt. Es reicht aus, wenn die Frontleisten 14 nur einen Steckkontakt 31 enthalten.

Die Ränder 26, 27 erstrecken sich nicht von Ecke zu Ecke der Abdeckplatten 15, 16. Es bleiben nahe an den Ecken Bereiche 33 frei, durch die die Profilschienen 3 bis 6 verlaufen, wenn die Abdeckplaten 15, 16 montiert sind.

Um den Baugruppenträger auch auf der Rückseite abzuschirmen, kann eine metallische Platte 34 oder eine Leiterplatte mit einer Metallbeschichtung über metallische Haltestücke 35 mit den Profilschienen 4, 6 verbunden werden. Die Platte 34 hat nicht näher dargestellte Durchlassöffnungen für Stifte 36 der Steckverbinder 13.

Durch die oben beschriebenen Massnahmen lässt sich eine gute Abschirmung des Inneren des Baugruppenträgers 1 erreichen. Je nach der Wellenform und der Frequenz der von der Schaltungsanordnung im Inneren des Baugruppenträgers 1 erarbeiteten Signale reicht die Dämpfung auch noch aus, wenn die Abdeckplatten 15, 16 mit Löchern für die Belüftung versehen sind.

Wenn die abschirmende Wirkung der leitenden Verbindungen der Frontleisten 14 zu den Profilschienen 7 nicht ausreicht, dann werden vorzugsweise leitende Verbindungen zwischen benachbarten Frontleisten auf die in Fig. 6 gezeigte Art hergestellt. Die Frontleiste 14 weist an ihren vertikalen Rändern 53, 54 gegen das Innere des Baugruppenträgers 1 gerichtete Leisten 55, 56 auf, die aus Metall bestehen oder metallisiert sind. In eine nicht näher bezeichnete Nut der vertikalen Leiste 56 ist eine Feder 57 eingesetzt, die über die Leiste 56 hinausragt. Die Leiste 55 ist als Kontaktfläche für die Feder 57 der benachbarten Frontplatte 14 ausgebildet. Zwischen den Frontplatten werden daher unmittelbar leitende Verbindungen hergestellt. Hierdurch wird die abschirmende Wirkung verbessert.

Wenn der Baugruppenträger auch auf seiner Rückseite eine besonders gute Abschirmung aufweisen soll, werden zwei Profilschienen 38, 39 an der Rückseite vorgesehen. Die Profilschiene 38 hat eine nach oben offene Profilschienennut 40 und eine nach hinten offene Profilschienennut 41. Die Profilschiene 39 hat eine nach unten offene Profilschienennut 42 und eine nach hinten offene Profilschienennut 43. Die Profilschienen sind mit Löchern 44 für Schraubverbindungen mit den Seitenwänden 2 versehen. In die Nuten 40, 41, die in gleicher Weise wie die Nuten 19 Vorsprünge und eingesetzte Federn 21 enthalten, sind metallische Abdeckplatten 45, 46 mit abgewinkelten Rändern eingesetzt. An ihren vorderen Rändern sind die Abdeckplatten 45, 46 in gleicher Weise wie die Abdeckplatten 15, 16 in Profilschienennuten 19 von Profilschienen 3, 5 eingesetzt. In den mit Vorsprüngen versehenen Nuten 19 sind Federn 21 vorgesehen, die eine leitende Verbindung zwischen Abdeckplatten 45, 46 und den Profilschienen 3, 5 herstellen. Innerhalb des von den Abdeckplatten 45, 46 begrenzten Raums können die Profilschienen angeordnet sein, die die rückseitigen Messerleisten 12 tragen. Die Abdeckplatten 45, 46 sind so lang ausgebildet, dass hinter den Messerleisten 12 noch ein Verdrahtungsraum 47 bleibt.

In die Nuten 41, 44, die ebenso wie die Nuten 19 und 40, 43 Vorsprünge aufweisen, in die Federn 21 eingesetzt sind, ist eine Abdeckplatte 48 mit abgewinkelten Rändern 49, 50 eingesetzt. die Abdeckplatte 48 ist an ihren vertikalen Rändern über nicht näher dargestellte abgewinkelte Ränder mit den entpsrechend länger ausgebildeten Seitenwänden 2 verbunden. Die Art der Befestigung entspricht derjenigen der Ränder 26, 27 an den Seitenwänden 2.

## Patentansprüche

1. Baugruppenträger mit einer oberen metallischen Abdeckplatte und mit zwei metallischen Seitenwänden, zwischen denen an den vier Ecken jeweils Profilschienen aus Metall verlaufen, die an den Seitenwänden befestigt sind und Führungshalter tragen, die für die Aufnahme von Baugruppen bestimmt sind, wobei die Abdeckplatte abgewinkelte Ränder aufweist, die sich über die Breite der Abdeckplatte und bis auf an den Ecken freie Bereiche über die Länge der Abdeckplatte erstrecken, und wobei die über die Länge der Abdeckplatte sich erstreckenden Ränder innen an den Seitenwänden angeschraubt sind,
**dadurch gekennzeichnet,**
daß eine untere metallische Abdeckplatte (16), die abgewinkelte Ränder (17, 18, 27) aufweist, die sich über die Breite der Abdeckplatte (16) und bis auf an den Ecken freie Bereiche über die Länge der Abdeckplatte (16) erstrecken mit den sich über die Länge der Abdeckplatte erstreckenden Rändern innen an den Seitenwänden (2) befestigt ist, und daß die in der Breite des Baugruppenträgers (1) verlaufenden Ränder (17, 18) der oberen und unteren Abdeckplatte (15, 16) je in eine Profilschienennut (19) ragen, in der eine oder mehrere Federn (21) Kräfte auf die Ränder (17, 18) und die Wand der Profilschienennut (19) ausüben.

2. Baugruppenträger nach Anspruch 1,
**dadurch gekennzeichnet,**
dass eine Profilschienennut (20) an ihrer Öffnung einen von einer Seitenwand ausgehenden, Leistenförmigen Vorsprung (20) aufweist, der die in der Profilschienennut (20) angeordnete Feder (21), die einen V-förmigen Querschnitt hat, zurückhält.

3. Baugruppenträger nach Anspruch 1 oder 2,
**dadurch gekennzeichnet,**
dass die Feder (21) mit ihren Enden dem Nutboden zugewandt ist.

4. Baugruppenträger nach einem oder mehreren der vorhergehenden Ansprüche,
**dadurch gekennzeichnet,**
dass an den Längsrändern der Feder (21) zackenförmige Vorsprünge (25) angeordnet sind.

5. Baugruppenträger nach einem oder mehreren der vorhergehenden Ansprüche,
**dadurch gekennzeichnet**,
dass die seitlichen Ränder (26, 27) vorspringende Noppen (30) aufweisen, die gegen die Seitenwände (2) angedrückt sind.

6. Baugruppenträger nach einem oder mehreren der vorhergehenden Ansprüche,
**dadurch gekennzeichnet,**
dass von metallischen oder metallisierten Frontplatten (14) der Baugruppen (11) jeweils Steckkontakte (31) ins Innere des Baugruppenträgers (1) vorspringen und dass die Steckkontakte in mit den Profilschienen (5) verbundene Federkontakte (32) einfügbar sind.

7. Baugruppenträgr nach Anspruch 6,
**dadurch gekennzeichnet,**
dass die metallischen oder metallisierten Frontplatten jeweils an den vertikalen Rändern (53, 54) ins Innere des Baugruppenträgers (1) ragende metallische oder metallisierte Leisten (55, 56) aufweisen, von denen eine eine Gleitfeder (57) trägt und die andere als Kontaktfläche für die leitende Verbindung mit der Gleitfeder (57) der Leiste (55) der im Baugruppenträger (1) benachbarten Frontplatte (14) ausgebildet ist.

8. Baugruppenträger nach einem oder mehreren der vorhergehenden Ansprüche,
**dadurch gekennzeichnet,**
dass rückwärtige Profilschienen (38, 39) des Baugruppenträgers (1) als Winkelschienen ausgebildet sind, die je mindestens zwei Profilschienennuten (40, 41; 42, 44) aufweisen, von denen eine den abgewinkelten Rand (17) der oberen oder unteren Abdeckplatte (45, 46) und eine nach hinten offene Profilschienennut (41, 44) eine den abgewinkelten Rand einer die Rückseite des Baugruppenträgers bedeckenden, metallischen Abdeckplatte (18) aufnimmt, wobei die Ränder der rückseitigen Abdeckplatte über Kontaktfedern mit den Wänden der Profilschienennuten (38, 39) leitend verbunden sind.

9. Baugruppenträger nach einem oder mehreren der Ansprüche 1 bis 4,
**dadurch gekennzeichnet**,
dass zwischen den seitlichen Rändern (26, 27) und den Seitenwänden Kontaktfedern angeordnet sind.

## Claims

1. Subassembly carrier with an upper metallic cover plate and with two metallic side walls, between which at the four corners respectively extend profile rails of metal, which are fastened to the side walls and carry guide mounts intended for the reception of subassemblies, wherein the cover plate has bent-over edges which extend over the width of the cover plate and - up to free regions at the corners - over the length of the cover plate and wherein the edges extending over the length of the cover plate are screw-connected at the inside to the side walls, characterised in that alower metallic cover plate (16) which has bent-over edges (17, 18, 27), which extend over the width of the cover plate (16) and - up to free regions at the corners - over the length of the cover plate (16), is fastened at the inside to the side walls (2) by the edges extending over the length of the cover plate, and that the edges (17, 18), which run in the width of the subassembly carrier (1), of the upper and lower cover plate (15, 16) each project into a profile rail groove (19), in which one or more springs (21) exert forces on the edges (17, 18) and the wall of the profile rail groove (19).

2. Subassembly carrier according to claim 1, characterised thereby that a profile rail groove (20) has at its opening a strip-shaped projection (20) which goes out from one side wall and which restrains the spring (21) which is arranged in the profile rail groove (20) and has a V-shaped cross-section.

3. Subassembly carrier according to claim 1 or 2, characterised thereby that the spring (21) faces the groove base by its ends.

4. Subassembly carrier according to one or more of the preceding claims, characterised thereby that jagged projections (25) are arranged at the longitudinal edges of the spring (21).

5. Subassembly carrier according to one or more of the preceding claims, characterised thereby that the lateral edges (26, 27) have projecting studs (30), which are pressed against the side walls (2).

6. Subassembly carrier according to one or more of the preceding claims, characterised thereby that plug contacts (31) project into the interior of the subassembly carrier (1) respectively from metallic or metallised front plates (14) of the subassemblies (11) and that the plug contacts are insertable into spring contacts (32) connected with the profile rails (5).

7. Subassembly carrier according to claim 6, characterised thereby that the metallic or metallised front plates respectively have at the vertical edges (53, 54) metallic or metallised strips (55, 56), which project into the interior of the subassembly carrier (1) and of which one carries a slide spring (57) and the other is constructed as a contact surface for conductive connection with the slide spring (57) of the strip (55) of the adjacent front plate (14) in the subassembly carrier (1).

8. Subassembly carrier acccording to one or more of the preceding claims, characterised thereby that rearward profile rails (38, 39) of the subassembly carrier (1) are constructed as angle rails, which each have at least two profile rail grooves (40, 41; 42, 44), of which one receives the bent-over edge (17) of the upper or lower cover plate (45, 46) and a downwardly open profile rail groove (41, 44) one receives the bent-over edge of a metallic cover plate (18) covering the rear side of the subassembly carrier, wherein the edges of the rearward cover plate are conductively connected with the walls of the profile rail grooves (38, 39) by way of contact springs.

9. Subassembly carrier according to one or more of claims 1 to 4, characterised thereby that contact springs are arranged between the lateral edges (26, 27) and the side walls.

## Revendications

1. Porte-modules comprenant une plaquette métallique de recouvrement supérieure et deux parois latérales métalliques entre lesquelles s'étendent, aux quatre coins, des glissières profilées en métal qui sont fixées aux parois latérales et portent des supports-guide qui sont destinés au logement de composants, la plaquette de recouvrement présentant des bords recourbés qui s'étendent sur la largeur de la plaquette de recouvrement et sur la longueur de la plaquette de recouvrement, excepté aux zones libres des angles, et les bords s'étendant sur la longueur de la plaquette de recouvrement étant vissés à l'intérieur aux parois latérales,
caractérisé en ce
qu'une plaquette de recouvrement inférieure métallique (16) présente des bords recourbés (17, 18, 27) qui s'étendent sur la largeur de la plaquette de recouvrement (16) et sur la longueur de la plaquette de recouvrement (16), excepté aux zones libres des angles, en ce que les bords, s'étendant sur la longueur de la plaquette de recouvrement, sont fixés à l'intérieur aux parois latérales (2) et en ce que les bords (17, 18), s'étendant sur la largeur du porte-modules (1) des plaquettes de recouvrement supérieure et inférieure (15, 16), s'engagent chacune dans une rainure (19) de glissière profilée dans laquelle un ou plusieurs ressorts (21) exercent des forces sur les bords (17, 18) et sur la paroi de la rainure (19) de glissière profilée.

2. Porte-modules selon la revendication 1,
caractérisé en ce
qu'une rainure (19) de glissière profilée présente, à son ouverture, une saillie (20) en forme de réglette partant d'une paroi latérale, qui maintient le ressort (21), de coupe transversale en V, disposé dans la rainure (19) de glissière profilée.

3. Porte-modules selon la revendication 1 ou 2,
caractérisé en ce que
les extrémités du ressort (21) sont tournées vers le fond de la rainure.

4. Porte-modules selon l'une ou plusieurs des revendications précédentes,
caractérisé en ce que
des saillies (25) en forme de dent sont disposées sur les bords longitudinaux des ressorts (21).

5. Porte-modules selon l'une ou plusieurs des revendications précédentes,
caractérisé en ce que
les bords latéraux (26, 27) présentent des crampons saillants (30) qui sont pressés contre les parois latérales (2).

6. Porte-modules selon l'une ou plusieurs des revendications précédentes,
caractérisé en ce que
depuis des plaquettes frontales métalliques ou métallisées (14) des modules (11), des contacts à fiches (31) font saillie dans l'intérieur du porte-modules (1) et en ce que les contacts à fiches sont enfichables dans les contacts à ressort (32) reliés aux glissières profilées (5).

7. Porte-modules selon la revendication 6 précédente,
caractérisé en ce que
les plaquettes frontales métalliques ou métallisées présentent, sur les bords verticaux (53, 54), des réglettes (55, 56) métalliques ou métallisées faisant saillie dans l'intérieur du porte-modules (1), dont l'une porte un ressort baladeur (57) et l'autre sert de surface de contact pour la connexion conductive avec le ressort baladeur (57) de la réglette (55) de la plaquette frontale (14) voisine dans le porte-modules (1).

8. Porte-modules selon l'une ou plusieurs des revendications précédentes,
caractérisé en ce que
des glissières profilées arrière (38, 39) du porte-modules (1) ont une forme angulaire présentant au moins deux rainures (40, 41 ; 42, 44) de glissière profilée dont l'une reçoit le bord recourbé (17) de la plaquette de recouvrement (45, 46) supérieure ou inférieure et dont une rainure de glissière profilée (41, 44) ouverte vers l'arrière reçoit une plaquette de recouvrement (18) métallique recouvrant le bord recourbé de la face arrière du porte-modules, les bords de la plaquette arrière de recouvrement étant reliés, par des ressorts de contact, aux parois des rainures (38, 39) de glissière profilée de manière conductrice.

9. Porte-modules selon l'une ou plusieurs des revendications 1 à 4,
caractérisé en ce que
des ressorts de contact sont disposés entre les bords latéraux (26, 27) et les parois latérales.
